# EUROPÄISCHE PATENTSCHRIFT

(11) **EP 1 976 358 B1**
(45) Veröffentlichungstag und Bekanntmachung des Hinweises auf die Patenterteilung: **24.04.2013**
(21) Anmeldenummer: 08004261.7
(22) Anmeldetag: 07.03.2008
(51) Int. Cl.: H05K 7/20

(54) **Anordnung mindestens eines Leistungshalbleitermoduls und einer Leiterplatte**
Assembly of at least one voltage semiconductor module and a conductor board
Agencement d'au moins un module semi-conducteur de puissance et une plaque conductrice

(30) Priorität: 28.03.2007 DE 102007014789
(43) Veröffentlichungstag der Anmeldung: 01.10.2008
(73) Patentinhaber: IXYS CH GmbH, 2555 Brügg (CH)
(72) Erfinder: Zschieschang, Olaf, 68519 Viernheim (DE); Laschek-Enders, Andreas, 64625 Bensheim (DE)
(74) Vertreter: Oppermann, Frank

(56) Entgegenhaltungen:
- US-A- 5 483 103
- US-A- 6 035 523
- US-A1- 2006 138 452
- US-B1- 6 180 436
- US-B1- 6 566 879
- US-B1- 6 633 485

## Beschreibung

Die Erfindung betrifft eine Anordnung aus mindestens einem Leistungshalbleitermodul und einer Leiterplatte.

Eine derartige Anordnung findet sich in verschiedenen Gebieten der Elektrotechnik, beispielsweise in einer Antriebssteuereinrichtung für einen Elektromotor. Die Schaltungsanordnung einer solchen Antriebssteuereinrichtung besteht aus verschiedenen Funktionsblöcken, beispielsweise Gleichrichtern, Wechselrichtern und Bremsstellern. Diese Funktionsblöcke werden durch Leistungshalbleiterbauteile und/oder Leistungshalbleitermodule gebildet, wobei letztere alle notwendigen Leistungshalbleiter und darüber hinaus weitere Komponenten enthalten können, beispielsweise Komponenten zur Überwachung der Leistungshalbleiter, die beispielsweise Temperatur- und / oder Stromsensoren aufweisen können. Die Leistungshalbleiterbauteile und/oder Leistungshalbleitermodule werden üblicherweise auf einer Leiterplatte angeordnet und durch Schrauben, Stecken oder Löten mit derselben verbunden.

Aus der EP 0 513 410 B1 und DE 196 46 396 C2 sind Leistungshalbleitermodule bekannt, die jeweils ein elektrisch isolierendes Substrat aufweisen, auf dem eine Schaltungsanordnung mit Leistungshalbleiterbauteilen angeordnet ist. Das Substrat bildet den Boden eines Kunststoffgehäuses, das die Schaltungsanordnung umschließt. Die mit der Schaltungsanordnung kontaktierten elektrischen Leistungsanschlüsse der Module erstrecken sich durch das Gehäuse nach außen. Das Gehäuse ist zum Schutz der Schaltungsanordnung mit Vergussmasse gefüllt. Befestigungspunkte am Gehäuse dienen der Verschraubung des Moduls mit einem Kühlkörper. Verschiedene Module werden zur Realisierung einer umfangreicheren Schaltung mittels Stromschienen miteinander verbunden. Eine solche Schienenverbindung wird in einer zweiten Ebene mit einem Abstand zum Kühlkörper vorgenommen, um ausreichende Luft- und Kriechstrecken zwecks elektrischer Isolation sicherzustellen. In der gleichen Ebene oder darüber schließen sich Beschaltungseinrichtungen und eine Elektronikplatine an, beispielsweise zur Ansteuerung der Leistungshalbleiterbauteile und zu deren Überwachung.

Dieser bekannte Aufbau von Leistungshalbleiterbauteilen und/oder Leistungshalbleitermodulen einschließlich Schutzeinrichtungen und Ansteuerelektronik erfordert einen hohen Materialaufwand und in der Fertigung zahlreiche Zwischenschritte sowie Schraub-, Löt- und Montageschritte. Weiterhin ist die durch die Verlustleistung beim Betrieb der Leistungshalbleitermodule verursachte Wärmeentwicklung im Regelfall auf relativ kleinen Flächen konzentriert. Diese Wärmeentwicklung kann die Leistung des Gesamtsystems und die Zuverlässigkeit der Leistungshalbleitermodule verringern. Daher bedarf es eines größeren Aufwandes zur Kühlung dieser Leistungshalbleitermodule.

Alternativ kommen in entsprechenden Aufbauten beispielsweise sogenannte diskrete Leistungshalbleiterbauteile zum Einsatz. Diese stellen in der Regel Einzelfunktionen in jeweils einem Gehäuse dar. Dabei sind Leistungshalbleiter direkt auf eine metallische Trägerplatte gelötet und zum Schutz umhüllt. Diese Bauteile können in der leistungselektronischen Anordnung räumlich verteilt werden, sodass eine bessere Verteilung der Wärme im Kühlkörper erzielt wird und gegebenenfalls der Aufwand zur Umsetzung einer angemessenen Kühlung reduziert werden kann. Sie zeichnen sich durch ein mechanisch robustes Design aus und sind als Elemente für verschiedenste Schaltungsfunktionen in standardisierten Bauformen durch hohe Stückzahlen kostengünstig verfügbar. Nachteilig ist, dass die Trägerplatte, welche der Wärmeabfuhr dient, vom Leistungshalbleiter nicht elektrisch isoliert ist und mithin ein elektrisches Potential führt. Bei der Montage von derartigen diskreten Leistungshalbleiterbauteilen auf einem gemeinsamen Kühlkörper ist daher eine zusätzliche Isolierung notwendig, die jedoch die Wärmeableitung an den Kühlkörper deutlich nachteilig beeinflusst. In der Regel werden diese Bauteile durch Schraub- oder Klemmmontage auf dem Kühlkörper befestigt, dies erfordert zusätzliche Montageteile, etwa Isolierplättchen und/oder Wärmeleitmaterialien, Schrauben, Montageklammern und einen entsprechenden Montageaufwand. Weiterhin muss man in der Regel Einschränkungen im Hinblick auf den Lötprozess in Kauf nehmen. Wegen der fehlenden Isolation werden Bauteile verwendet, die in ihren Abmessungen und anderen Eigenschaften zu den beschriebenen Bauteilen vergleichbar sind, bei denen jedoch keine massive metallische Trägerplatte zum Einsatz kommt, sondern eine beidseitig metallisierte keramische Grundplatte Verwendung findet. Solche Bauteile sind beispielsweise in der DE 196 25 240 B4 und US 6 404 065 beschrieben. Gleichwohl sind auch hier zusätzliche Montageteile und spezielle Montageschritte für die Montage auf dem Kühlkörper und ggf. beim Löten in die Leiterplatte notwendig.

Die Anschlusskämme von Bauteilen, die der elektrischen Kontaktierung dienen, werden in der Regel flach nach den Seiten herausgeführt. Damit besteht für viele Anwendungen das Problem der Einhaltung von Luft- und Kriechstrecken zwischen den Anschlüssen mit verschiedenen Spannungspotentialen einerseits und zwischen den Anschlüssen und der metallisierten Trägerplatte bzw. dem Kühlkörper in der Anwendung andererseits.

Die WO94/29901 beschreibt eine Anordnung, die eine Leiterplatte mit Leiterbahnen, auf der Leiterplatte angeordneten und mit den Leiterbahnen kontaktierten Halbleiterbauelementen und einen Kühlkörper umfasst. Die Leiterplatte ist mit einem Steg des T-förmigen Kühlkörpers verschraubt. Zwischen dem Kühlkörper und der Leiterplatte ist ein Federkörper angeordnet, der zwei seitliche Federzungen aufweist, die durch ihre Biegung und Vorspannung die Halbleiter gegen den Kühlkörper drücken sollen.

Die US 6,180,436 B1 beschreibt eine Anordnung mit einem Kühlkörper und einer Leiterplatte, die ein Leistungshalbleitermodul trägt. Zwischen Kühlkörper und Leistungshalbleitermodul befinden sich aber keine plastischen oder elastischen Mittel.

Die US 2006/138452 A1 offenbart eine Anordnung, bei der plastische Mittel zwischen einem Gehäuse und einem Kühlkörper angeordnet sind.

Aus der US 6,035,523 A ist eine Anordnung aus einer Leiterplatte, einem Halbleitermodul und einem Kühlkörper bekannt, bei dem ein thermoplastisches Material zwischen Halbleiterbauelement und Leiterplatte eingebracht ist, das das Halbleiterbauelement tragen soll.

Der Erfindung liegt die Aufgabe zugrunde, eine Anordnung eines Leistungshalbleitermoduls und einer Leiterplatte mit verbesserten technischen Eigenschaften bereitzustellen.

Der Erfindung liegt auch die Aufgabe zugrunde, eine kostengünstigere, kompaktere Anordnung eines Leistungshalbleitermoduls und einer Leiterplatte bereitzustellen, die einen kleineren Montageaufwand erfordert.

Diese Aufgaben werden erfindungsgemäß mit den Merkmalen des Patentanspruchs 1 gelöst. Bevorzugte. Ausführungsformen der Erfindung sind Gegenstand der Unteransprüche.

Die erfindungsgemäße Anordnung umfasst mindestens ein Leistungshalbleitermodul und eine Leiterplatte mit Leiterbahnen, wobei das Leistungshalbleitermodul ein Gehäuse mit Leistungsanschlüssen aufweist, die sich durch das Gehäuse nach außen erstrecken und mit den Leiterbahnen der Leiterplatte kontaktiert sind.

Die erfindungsgemäße Anordnung zeichnet sich dadurch aus, dass zwischen dem Gehäuse des Leistungshalbleitermoduls und der Leiterplatte elastisch oder plastisch verformbare Mittel angeordnet sind, über die eine Anpresskraft von der Leiterplatte auf das Gehäuse übertragbar ist. Dadurch werden die Leistungsanschlüsse des Leistungshalbleitermoduls entlastet. Es besteht somit nicht die Gefahr des Verbiegens der Anschlusselemente. Darüber hinaus wird sichergestellt, dass ein vorgegebener Abstand zwischen den Anschlusselementen und der Metallisierung der Leiterplatte eingehalten wird. Von Vorteil ist, wenn die elastisch oder plastisch verformbaren Mittel aus einem wärmeleitenden Material bestehen.

Darüber hinaus umfasst die Anordnung mindestens ein Anpresselement, das an der dem Leistungshalbleitermodul abgewandten Seite der Leiterplatte angeordnet ist, und mindestens einen Kühlkörper, der an der Seite des Leistungshalbleitermoduls angeordnet ist, die der Leiterplatte abgewandt ist. Das Anpresselement ist einstückig mit einem ersten Gehäuseteil eines Gehäuses ausgebildet, während der Kühlkörper einstückig mit einem zweiten Gehäuseteil des Gehäuses ausgebildet ist. Dabei umschließen die beiden Gehäuseteile die Leiterplatte zusammen mit den an der Leiterplatte angebrachten elektronischen Bauteilen.

Unter elastisch oder plastisch verformbaren Mitteln werden alle Mittel verstanden, mit denen die Leistungsanschlüsse entlastet werden, wenn auf die Leiterplatte der erfindungsgemäßen Anordnung eine Anpresskraft ausgeübt wird. Vorzugsweise sind die Mittel elastisch verformbar, so dass sie eine Rückstellkraft ausüben können. Es ist aber grundsätzlich auch möglich, dass die Mittel plastisch verformbar sind, so dass sich die Leiterplatte an den plastisch verformbaren Mitteln, nicht aber den Anschlusselementen abstützt.

Bei einer bevorzugten Ausführungsform der Erfindung sind die elastisch oder plastisch verformbaren Mittel als mindestens ein Federelement ausgebildet, das derart verformt ist, dass das Federelement mindestens eine nach außen gewölbte Fläche zur Anlage der Leiterplatte aufweist, wobei die Anlagefläche unter Druck federnd nachgibt. Dabei ist das Federelement vorzugsweise klemmend auf das Gehäuse des Leitungshalbleitermoduls aufgesetzt ist. Hierzu kann das Federelement das Gehäuse seitlich übergreifende Klammern aufweisen. Das Federelement besteht vorzugsweise aus Metall, beispielsweise einem Federstahl.

Das Federelement kann beispielsweise eine nach außen gebogene Metallklammer sein.

Eine alternative Ausführungsform sieht vor, dass die elastisch oder plastisch verformbaren Mittel als mindestens ein elastisch oder plastisch verformbares Kissen zwischen Leistungshalbleitermodul und einer Leiterplatte ausgebildet sind. Das elastisch oder plastisch verformbare Kissen kann auf der Oberfläche des Gehäuses des Leistungshalbleitermoduls befestigt sein oder in eine Ausnehmung oder Vertiefung des Gehäuses eingesetzt sein. Vorzugsweise ist das Kissen mit dem Gehäuse des Leistungshalbleitermoduls verklebt. Das Kissen kann aber auch dadurch gebildet werden, dass die Anordnung des Leistungshalbleitermoduls nach dem Verlöten mit einer Leiterplatte mittels einer elastisch verformbaren und elektrisch isolierenden Masse, beispielsweise Silikonkautschuk, vergossen wird.

Das elastisch oder plastisch verformbare Kissen kann aus unterschiedlichen Materialien bestehen, die plastische und/oder elastische und vorzugsweise elektrisch isolierende Eigenschaften haben. Entscheidend ist, dass das Kissen die vom Anpresselement auf das Gehäuse des Leistungshalbteilermoduls ausgeübte Kraft aufnimmt und somit das Gehäuse an eine Kühlplatte zur verbesserten thermischen Ankopplung dauerhaft andrückt. Dabei werden auch die elektrischen Anschlusselemente des Leistungshalbleitermoduls entlastet. Zudem stellt das elektrisch isolierende Kissen die Einhaltung der für den elektrischen Betrieb geforderten Isolationsabstände für Luft- bzw. Kriechstrecken zwischen den elektrischen Anschlüssen und der Leiterplatte sicher. Außerdem kann das Kissen zusammen mit den Leistungsanschlüssen temperaturbedingte Verformungen des Leistungshalbleitermoduls ausgleichen, die auf die verschiedenen thermischen Ausdehnungskoeffizienten der im Leistungshalbleitermodul enthaltenen Materialien zurückzuführen sind.

Das mindestens eine Leistungshalbleitermodul umfasst vorzugsweise eine Trägerplatte aus isolierendem Keramiksubstrat, die den Boden des Gehäuses bildet. Die Trägerplatte ist auf einer Seite mit einer entsprechend einer Schaltungsanordnung des Leistungshalbleitermoduls strukturierten Metallschicht und auf der dieser Seite gegenüberliegenden Seite bzw. Außenseite mit einer durchgehenden Metallschicht versehen, die der thermischen Anbindung des Leistungshalbleitermoduls an einen Kühlkörper dient. Auf der strukturierten Metallschicht ist mindestens ein Leistungshalbleiterbauteil angeordnet und unterseitig mit derselben verlötet sowie oberseitig mittels elektrischer Verbindungselemente, die vorzugsweise als Bonddrähte ausgebildet sind, mit derselben kontaktiert.

Auf der Seite der Leiterplatte, die dem Leistungshalbleitermodul abgewandt ist, können zwischen dem Anpresselement und der Leiterplatte ebenfalls elastisch oder plastisch verformbare Mittel angeordnet sein, um einen durch Bauteiltoleranzen bedingten Abstand zwischen der Leiterplatte und dem Anpresselement auszugleichen. Dadurch wird unabhängig von Bauteiltoleranzen sichergestellt, dass das Anpresselement eine genügend große Kraft auf die Leiterplatte ausübt.

Im Folgenden werden Ausführungsbeispiele der Erfindung unter Bezugnahme auf die Figuren näher erläutert. Es zeigen:
- Fig. 1: eine erste Ausführungsform des erfindungsgemäßen Leistungshalbleitermoduls,
- Fig. 2: eine Anordnung aus dem Leistungshalbleitermodul von Fig. 1 und einer Leiterplatte, und
- Fig. 3: die erfindungsgemäßen Anordnung mit dem erfindungsgemäßen Leistungshalbleitermodul von Fig. 1,
- Fig. 4: eine zweite Ausführungsform des erfindungsgemäßen Leistungshalbleitermoduls,
- Fig. 5: eine weitere Ausführungsform des erfindungsgemäßen Leistungshalbleitermoduls und
- Fig. 6: eine erfindungsgemäße Anordnung aus dem Leistungshalbleitermodul von Fig. 5 und einer Leiterplatte.

Das erfindungsgemäße Leistungshalbleitermodul 1 umfasst ein vorzugsweise aus einer Epoxidmasse gefertigtes Gehäuse 9 und eine Trägerplatte 5 aus einem isolierenden Keramiksubstrat, wobei die Trägerplatte 5 den Boden des Gehäuses 9 bildet. Grundsätzlich kann das Gehäuse 9 auch aus Metall gefertigt sein. Die Trägerplatte 5 ist sowohl auf ihrer dem Gehäuse 9 zugewandten Seite als auch auf ihrer dem Gehäuse 9 abgewandten Seite bzw. Außenseite mit einer Metallschicht 5.2, 5.3 versehen, wobei die erstere Metallschicht 5.2 entsprechend der Leiterbahnen einer Schaltungsanordnung strukturiert ist. Auf dieser strukturierten Metallschicht 5.2 ist ein Leistungshalbleiterbauteil 6 angeordnet und unterseitig mit derselben verlötet. Oberseitig ist das Leistungshalbleiterbauteil 6 vorzugsweise mittels Bonddrähten 8 mit Leiterbahnen der strukturierten Metallschicht 5.2 kontaktiert, wobei der Bonddraht 8 jeweils mit dem Leistungshalbleiterbauteil 6 und der Leiterbahn verlötet ist. Zwei vorzugsweise laschenförmig ausgebildete Leistungsanschlüsse 7 bilden die elektrischen Anschlüsse des Leistungshalbleitermoduls 1, die an ihren Enden innerhalb des Gehäuses 9 jeweils mit einer Leiterbahn der Schaltungsanordnung verlötet sind und sich jeweils durch das Gehäuse 9 vorzugsweise seitlich nach außen erstrecken. Die beiden äußeren Enden der Leistungsanschlüsse 7 sind als Anschlüsse eines oberflächenmontierten Bauteils bzw. SMD Bauteils (**S**urface-**M**ounted **D**evice) mit lötfähigen Anschlussflächen ausgebildet. Grundsätzlich müssen die elektrischen Anschlüsse 7 des Leistungshalbleitermoduls 1 nicht als SMD Bauteile ausgebildet sein. Vielmehr können diese mit der Leiterplatte 3, auf der das Leistungshalbleitermodul aufgesetzt wird, verschraubt oder in diese gesteckt sein.

Zur Einhaltung der für den elektrischen Betrieb geforderten Isolationsabstände für Luft- und Kriechstrecken zwischen den innerhalb des Gehäuses 9 liegenden Abschnitten der elektrischen Anschlüsse 7 und der Trägerplatte 5 und zwischen den außerhalb des Gehäuses 9 liegenden Abschnitten der elektrischen Anschlüssen 7 und der Leiterplatte 3 sowie einem Kühlkörper 11, sind die Leistungsanschlüsse 7 derart ausgebildet, dass sich die Anschlüsse 7 innerhalb des Gehäuses 9 zuerst im Wesentlichen senkrecht von der Trägerplatte 5 weg, dann seitlich durch das Gehäuses 9 nach außen und dann im Wesentlichen senkrecht zur Leiterplatte 3 erstrecken.

Das Gehäuse 9 weist an einer der Trägerplatte 5 abgewandten Außenseite zwei im Abstand zueinander angeordnete Kissen 4 aus einem elastisch und/oder plastisch verformbaren Material auf, das der Abstützung der Leiterplatte 3 beim Anpressen des Gehäuses 9 gegen den Kühlkörper 11 mittels eines Anpresselements 12 dient. An der Außenseite des Gehäuses 9 können zwei Vertiefungen vorgesehen sein, in denen die beiden Kissen sitzen. Die beiden Kissen 4 sind jeweils modulseitig mit einer Klebschicht versehen und mit der Außenseite des Gehäuses 9 verklebt. Dabei können die Kissen 4 bereits bei der Fertigung des Leistungshalbleitermoduls 1 mit dessen Gehäuse verklebt werden, was die Montage einer derartigen Anordnung vereinfacht.

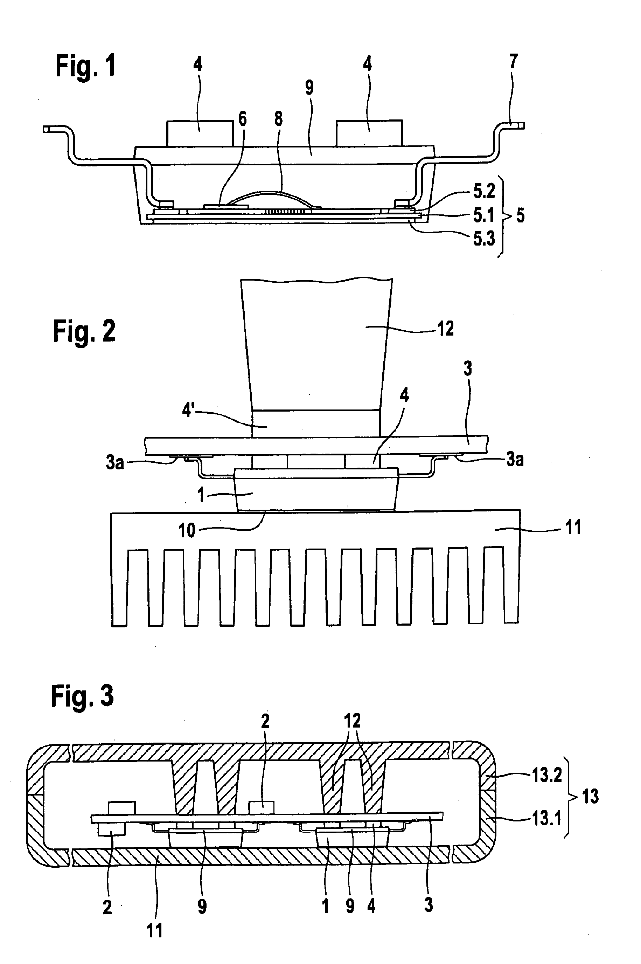

Bei dem Ausführungsbeispiel von Fig. 2 ist das erfindungsgemäße Leistungshalbleitermodul 1 derart mit den Leiterbahnen 3a einer Leiterplatte 3 verlötet, dass die beiden Kissen 4 zwischen dem Gehäuse 9 des Leistungshalbleitermoduls 1 und der Leiterplatte 3 angeordnet sind. Das Anpresselement 12, das an einer dem Leistungshalbleitermodul 1 abgewandten Seite der Leiterplatte 3 angeordnet ist, drückt die Leiterplatte 3 gegen die beiden Kissen 4 und somit das Leistungshalbleitermodul 1 gegen einen Kühlkörper 11, wobei die Außenseite der Trägerplatte 5 am Kühlkörper 11 anliegt. Zur Verbesserung der Wärmeleitfähigkeit trägt eine zwischen der metallischen Außenseite der Trägerplatte 5 und dem Kühlkörper 11 befindliche Wärmeleitpaste bei.

Die beiden Kissen 4 nehmen die von dem Anpresselement 12 auf das Gehäuse 9 des Leistungshalbteilermoduls 1 ausgeübten Kräfte auf und entlasten somit die elektrischen Anschlüsse 7 des Leistungshalbleitermoduls 1. Dadurch wird die Verformung der elektrischen Anschlüsse 7 verhindert, so dass das Leistungshalbleitermodul 1 von der Leiterplatte 3 beabstandet bleibt. Folglich stellen die Kissen 4 die Einhaltung der für den elektrischen Betrieb geforderten Isolationsabstände für Luft- bzw. Kriechstrecken zwischen den elektrischen Anschlüssen 7 und der Leiterplatte 3 sicher. Außerdem gleichen die Kissen 4 zusammen mit den Leistungsanschlüssen 7 temperaturbedingte Verformungen des Leistungshalbleitermoduls 1 aus, die auf die verschiedenen thermischen Ausdehnungskoeffizienten der im Leistungshalbleitermodul 1 enthaltenen Materialien zurückzuführen sind.

Zwischen dem Anpresselement 12 und der Leiterplatte kann ein zusätzliches Kissen 4' aus einem elastischen und/oder plastischen Material angeordnet sein, das einen durch Bauteiltoleranzen bedingten Abstand zwischen der Leiterplatte 3 und dem Anpresselement 12 ausgleichen kann, so dass sichergestellt ist, dass das Anpresselement 12 eine genügend große Kraft auf die Leiterplatte 3 ausübt. Ein zusätzliches Kissen zwischen Anpresselement und Leiterplatte ist aber bei den in der Praxis vorliegenden Bauteiltoleranzen im Allgemeinen nicht erforderlich.

Fig. 3 zeigt die erfindungsgemäßen Anordnung, bei der das Anpresselement 12 einstückig mit einem ersten Gehäuseteil 13.2 ausgebildet ist, der den Deckel eines Gehäuses 13 aus Metall bildet, vorzugsweise zum Beispiel aus Gusseisen, wohingegen der Kühlkörper 11 einstückig mit einem zweiten Gehäuseteil 13.1 des Gehäuses 13 ausgebildet ist. Dabei umschließen die beiden Gehäuseteile 13.1, 13.2 die Leiterplatte 3 zusammen mit der den an der Leiterplatte angebrachten elektronischen Bauteile 1, 2. Im Unterschied zur erfindungsgemäßen Anordnung gemäß Fig. 2 ist bei dieser Anordnung für jedes Kissen 4 ein separates Anpresselement 12 vorgesehen.

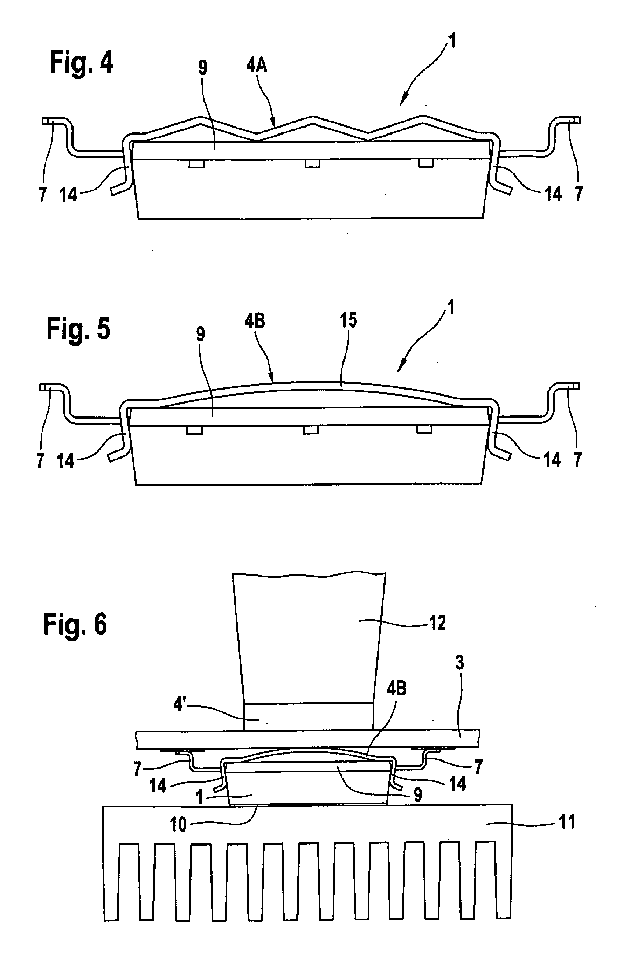

Fig. 4 zeigt eine alternative Ausführungsform des erfindungsgemäßen Leistungshalbleitermoduls, wobei für die einander entsprechenden Bauteile wieder die gleichen Bezugszeichen wie in den vorhergehenden Figuren verwendet werden. Diese Ausführungsform unterscheidet sich von der Ausführungsform von Fig. 1 dadurch, dass anstelle eines Kissens ein Federelement 4A vorgesehen ist. Das Federelement 4A ist eine dünne aus Federstahl bestehende Platte, die zickzackförmig geformt und an ihren Rändern seitlich umgebogen ist. Die beiden seitlich umgebogenen Ränder des Federelementes bilden Klammern 14, die das Gehäuse des Leistungshalbleitermoduls seitlich umgreifen und das Federelement an dem Gehäuse sichern. Die dünne Platte aus Federstahl ist derart verformt, dass sich die Platte zusammendrücken lässt, wenn von oben eine Anpresskraft auf die Platte ausgeübt wird. Da die beiden Klammern 14 leicht nach innen gebogen sind, wird eine ausreichende Klemmspannung auch dann erreicht, wenn das Federelement an das Gehäuse angedrückt wird.

Fig. 5 zeigt eine alternative Ausführungsform, die sich von dem Ausführungsbeispiel von Fig. 4 durch das Federelement unterscheidet. Das Federelement 4B von Fig. 5 ist eine dünne Platte aus Federstahl, die an ihren Rändern umgebogen ist. Zwischen den beiden Rändern, die wieder Klammern 14 zum Befestigen des Federelementes an dem Gehäuse dienen, ist die dünne Platte nach außen gewölbt. Dadurch wird eine nach außen gewölbte Anlagefläche 15 für die Leiterplatte geschaffen, die unter Druckbeanspruchung nachgibt.

Die Federelemente 4A, 4B von Fig. 4 oder Fig. 5 können auch aus einem flexiblen elastisch verformbaren Kunststoff, beispielsweise als Spritzgießteil in großen Stückzahlen kostengünstig gefertigt sein. Sie können einen zickzackförmig geformten bzw. einen nach außen gewölbten Bereich oder auch mehrere Abschnitte jeweils mit einem zickzackförmig geformten bzw. nach außen gewölbten Bereich aufweisen.

Fig. 6 zeigt die erfindungsgemäße Anordnung, die das Leistungshalbleitermodul 1 von Fig. 5 und die Leiterplatte 3 umfasst, wobei das Federelement 4B zwischen Leiterplatte und dem Gehäuse 9 des Leistungshalbleitermoduls 1 angeordnet ist. Dabei stützt sich die Leiterplatte 3 an der nach außen gewölbten Anlagefläche 15 des Federelementes 4B ab. Anstelle des Leistungshalbleitermoduls von Fig. 5 kann die Anordnung aber auch das Leistungshalbleitermodul von Fig. 4 aufweisen.

## Patentansprüche

1. Anordnung mit
einer Leiterplatte (3) mit Leiterbahnen,
mindestens einem Leistungshalbleitermodul (1), das ein Gehäuse (9) mit Leistungsanschlüssen (7) aufweist, die sich durch das Gehäuse (9) nach außen erstrecken und mit den Leiterbahnen (3a) der Leiterplatte (3) kontaktiert sind, und
mindestens einem Kühlkörper (11), der an der Seite des Leistungshalbleitermoduls angeordnet ist, die der Leiterplatte abgewandt ist,
wobei zwischen dem Gehäuse (9) des Leistungshalbleitermoduls (1) und der Leiterplatte (3) elastisch oder plastisch verformbare Mittel (4) angeordnet sind, über die eine Anpresskraft von der Leiterplatte auf das Gehäuse unter Entlastung der Leistungsanschlüsse (7) übertragbar ist,
**dadurch gekennzeichnet, dass**
die Anordnung mindestens ein Anpresselement (12) umfasst, das an der dem Leistungshalbleitermodul (1) abgewandten Seite der Leiterplatte (3) angeordnet ist, wobei das Anpresselement (12) einstückig mit einem ersten Gehäuseteil (13.2) eines Gehäuses (13) und der Kühlkörper (11) einstückig mit einem zweiten Gehäuseteil (13.1) des Gehäuses (13) ausgebildet sind, wobei die beiden Gehäuseteile die Leiterplatte (3) umschließen.

2. Anordnung nach Anspruch 1, **dadurch gekennzeichnet, dass** die elastisch oder plastisch verformbaren Mittel (4) als mindestens ein Federelement (4A, 4B) ausgebildet sind, das derart verformt ist, dass das Federelement mindestens eine nach außen gewölbte Fläche (15) zur Anlage der Leiterplatte (3) aufweist, wobei die Anlagefläche unter Druck federnd nachgibt.

3. Anordnung nach Anspruch 2, **dadurch gekennzeichnet, dass** das Federelement (4A, 4B) klemmend auf das Gehäuse (9) des Leitungshalbleitermoduls (1) aufgesetzt ist.

4. Anordnung nach Anspruch 2 oder 3, **dadurch gekennzeichnet, dass** das Federelement (4A, 4B) das Gehäuse (9) seitlich übergreifende Klammern (15) aufweist.

5. Anordnung nach Anspruch nach einem der Ansprüche 2 bis 4, **dadurch gekennzeichnet, dass** das Federelement (4A, 4B) aus Metall besteht.

6. Anordnung nach Anspruch 1, **dadurch gekennzeichnet, dass** die elastisch oder plastisch verformbaren Mittel (4) als mindestens ein elastisch oder plastisch verformbares Kissen ausgebildet sind.

7. Anordnung nach Anspruch 6, **dadurch gekennzeichnet, dass** das mindestens eine elastisch oder plastisch verformbare Kissen (4) mit der Außenseite des Gehäuses (9) verklebt ist.

8. Anordnung nach einem der Ansprüche 1 bis 7, **dadurch gekennzeichnet, dass** das Leistungshalbleitermodul (1) eine Trägerplatte (5) aus isolierender Keramik aufweist, die den Boden des Gehäuses (9) des Leistungshalbleitermoduls (1) bildet, wobei die Trägerplatte (5) eine als Schaltungsanordnung strukturierte Metallschicht (5.2) aufweist, und das Leistungshalbleitermodul (1) mindestens ein Leistungshalbleiterbauteil (6) aufweist, das auf der strukturierten Metallschicht (5.2) der Trägerplatte (5) angeordnet und unterseitig mit derselben verlötet sowie oberseitig mittels elektrischer Verbindungselemente (7.1) mit derselben kontaktiert ist.

9. Anordnung nach einem der Ansprüche 1 bis 8, **dadurch gekennzeichnet, dass** die Leistungsanschlüsse (7) des Leistungshalbleitermoduls (1) als Anschlüsse eines oberflächenmontierten Bauteils ausgebildet sind, wobei die Leistungsanschlüsse (7) einen sich seitlich nach außen durch das Gehäuse erstreckenden Abschnitt aufweisen, an den sich ein dazu im Wesentlichen senkrecht verlaufender Abschnitt anschließt.

10. Anordnung nach einem der Ansprüche 1 bis 9, **dadurch gekennzeichnet, dass** das Gehäuse (9) aus einer Epoxidmasse besteht oder ein Metallgehäuse ist.

## Claims

1. Assembly comprising
a conductor board (3) having conductor tracks,
at least one voltage semi-conductor module (1), comprising a housing (9) with power connections (7), which project outwards from the housing (9) and are in contact with the conductor tracks (3 a) of the conductor board, and
at least one cooling body (11), which is arranged on the side of the voltage semi-conductor module that faces the voltage semi-conductor,
whereby between the housing (9) of the voltage semi-conductor module (1) and the conductor board (3), either elastically or plastically deformable means (4) are arranged, through which a pressure force from the conductor board onto the housing can be transferred while reducing the pressure on the power connections (7),
**characterised in that**,
the assembly comprises at least one pressure element (12), which is arranged on the side of the voltage semi-conductor (1) facing away from the conductor board (3), whereby the pressure element (12) is in the form of a single piece together with a first housing part (13.2) of a housing (13) and the cooling body (11) is in the form of a single piece together with a second housing part (13.1) of the housing (13), whereby the two housing parts enclose the conductor board (3).

2. Assembly according to Claim 1 above, **characterised in that** the either elastically or plastically deformable means (4) are in the form of a spring element (4A, 4B), that is deformed in such a way that the spring element comprises at least one convex surface (15) for application onto the conductor board (3), whereby the application surface under pressure yields resiliently.

3. Assembly according to Claim 2 above, **characterised in that** the spring element (4A, 4B) is arrange in a clamped manner on the housing (9) of the voltage semiconductor module (1).

4. Assembly according to Claim 2 or 3 above, **characterised in that** the spring element (4A, 4B) comprises braces (15) that laterally cross over the housing (9).

5. Assembly according to any of the above Claims 2 to 4, **characterised in that** the spring element (4A, 4B) is made of metal.

6. Assembly according to Claim 1 above, **characterised in that** the elastically or plastically deformable means (4) are in the form of at least one elastically or plastically deformable cushion.

7. Assembly according to Claims 6, **characterised in that** at least one elastically or plastically deformable cushion (4) is stuck to the outside of the housing (9).

8. Assembly according to any of the preceding Claims 1 to 7, **characterised in that** the voltage semiconductor module (1) comprises a mounting plate (5) in an insulating ceramic, which forms the bottom of the housing (9) of the voltage semiconductor module (1), whereby the mounting plate (5) comprises a metallic layer (5.2) that is structured as a switching layer, and the voltage semiconductor module (1) comprises at least one voltage semiconductor component (6) that is arranged on the structured metallic layer (5.2) of the mounting plate (5) and is soldered to the latter at the bottom side and also brought into contact with this at the top side by means of electrical connection elements (7.1).

9. Assembly according to any of the preceding Claims 1 to 8, **characterised in that** the power contacts (7) of the voltage semiconductor module (1) are in the shape of the contacts of a surface-mounted component, whereby the power contacts (7) have a section that extends laterally outwards through the housing, to which an essentially vertically running section connects.

10. Assembly according to any of the preceding Claims 1 to 9, **characterised in that** the housing (9) is made of an epoxy resin or is in the form of a metal housing.

## Revendications

1. Agencement comprenant
un circuit imprimé (3), muni de pistes conductrices,
au moins un module semi-conducteur de puissance (1), qui comprend un boîtier (9) pourvu de connexions de puissance (7) qui s'étendent vers l'extérieur au travers dudit boîtier (9), et sont en contact avec lesdites pistes conductrices (3a) dudit circuit imprimé (3),
et
au moins un corps de refroidissement (11) agencé du côté dudit module semi-conducteur de puissance qui est opposé au circuit imprimé,
sachant que, entre le boîtier (9) du module semi-conducteur de puissance (1) et le circuit imprimé (3), des moyens déformables élastiquement ou plastiquement (4) sont agencés, grâce auxquels une force de contact est transmise du circuit imprimé sur le boîtier par décharge des connexions de puissance (7),
**caractérisé en ce que**
ledit agencement inclut au moins un élément à pression de contact (12), agencé du côté du circuit imprimé (3) qui est opposé au module semi-conducteur de puissance (1), ledit élément à pression de contact (12) étant venu de matière avec une première partie (13.2) d'un carter (13) et le corps de refroidissement (11) étant venu de matière avec une seconde partie (13.1) dudit carter (13), les deux parties dudit carter encapsulant ledit circuit imprimé (3).

2. Agencement selon la revendication 1, **caractérisé en ce que** les moyens déformables élastiquement ou plastiquement (4), sont réalisés sous la forme d'au moins un élément formant ressort (4A, 4B) déformé de façon telle que ledit élément formant ressort offre au moins une surface (15) bombée vers l'extérieur prévue pour venir en butée contre le circuit imprimé (3), ladite surface prévue pour venir en butée cédant élastiquement sous l'effet d'une pression.

3. Agencement selon la revendication 2, **caractérisé en ce que** l'élément formant ressort (4A, 4B) est mis en place par serrage sur le boîtier (9) du module semi-conducteur de puissance (1).

4. Agencement selon la revendication 2 ou 3, **caractérisé en ce que** l'élément formant ressort (4A, 4B) comporte des agrafes (15) venant coiffer latéralement le boîtier (9).

5. Agencement selon l'une des revendications 2 à 4, **caractérisé en ce que** l'élément formant ressort (4A, 4B) est en métal.

6. Agencement selon la revendication 1, **caractérisé en ce que** les moyens déformables élastiquement ou plastiquement (4), sont réalisés sous la forme d'au moins un coussin élastiquement ou plastiquement déformable.

7. Agencement selon la revendication 6, **caractérisé en ce que** le au moins un coussin élastiquement ou plastiquement déformable (4), est collé à la face extérieure du boîtier (9).

8. Agencement selon l'une des revendications 1 à 7, **caractérisé en ce que** le module semi-conducteur de puissance (1) comporte une platine de support (5) en céramique isolante, qui forme le fond du boîtier (9) dudit module semi-conducteur de puissance (1), ladite platine de support (5) comprenant une couche métallique (5.2) structurée en un circuit de branchement, et ledit module semi-conducteur de puissance (1) présente au moins un composant semi-conducteur de puissance (6) qui est disposé sur la couche métallique structurée (5.2) de ladite platine de support (5), et qui est brasé sur cette dernière sur sa face inférieure, et qui est en contact avec cette dernière sur sa face supérieure, au moyen d'éléments électriques de liaison (7.1).

9. Agencement selon l'une des revendications 1 à 8, **caractérisé en ce que** les connexions de puissance (7) du module semi-conducteur de puissance (1) sont réalisées sous la forme de connexions d'un composant monté en surface, lesdites connexions de puissance (7) comportant une portion qui traverse latéralement vers l'extérieur le boîtier, et à laquelle se rattache en outre une portion s'étendant pour l'essentiel perpendiculairement à cette dernière.

10. Agencement selon l'une des revendications 1 à 9, **caractérisé par le fait que** le boîtier (9) est constitué d'une masse d'époxyde, ou se présente comme un boîtier métallique.
